(19) **Europäisches Patentamt**

**European Patent Office**

**Office européen des brevets**

(11) Veröffentlichungsnummer: **0 031 181**
**A2**

(12) # EUROPÄISCHE PATENTANMELDUNG

(21) Anmeldenummer: **80201173.4**

(22) Anmeldetag: **08.12.80**

(51) Int. Cl.³: **H 05 K 7/14**

(30) Priorität: **21.12.79 CH 11387/79**

(43) Veröffentlichungstag der Anmeldung:
**01.07.81 Patentblatt 81/26**

(84) Benannte Vertragsstaaten:
**CH DE FR GB LI SE**

(71) Anmelder: **BBC Brown, Boveri & Cie.**
**(Aktiengesellschaft)**

**CH-5401 Baden(CH)**

(72) Erfinder: **Kohl, Gerhard**
**Beusheimer Ring 23d**
**D-6710 Frankenthal(DE)**

(72) Erfinder: **Roth, Walter**
**Haldenweg 9**
**D-7896 Wutöschingen 4 Horheim(DE)**

(54) **Ein- Ausziehvorrichtung für Baugruppen.**

(57) Ein- Ausziehvorrichtung für Baugruppen. In elektrischen Geräten mit mehreren Steckbaugruppen (2) sind zur elektrischen Kontaktierung der auf ihnen angebrachten Leiterbahnen an der Rückseite dieser Baugruppen üblicherweise Mehrfachsteckvorrichtungen (5) vorgesehen, deren Stecker in Federkontakte eingeschoben werden. Zum Einschieben und Herausziehen sind erhebliche Kräfte und eine einwandfreie Führung (3,4) erforderlich. Dazu wird eine im Aufbau einfache und vielseitig verwendbare Ein- Ausziehvorrichtung angegeben. Ein an der Frontplatte (16) der Baugruppe (2) schwenkbar gelagerter Spannhebel (21) umgreift mit seinen Teilhebelarmen einen Arretiersteg (12). Eine Führungsöffnung zwischen den Teilhebelarmen ist im wesentlichen kreiszylindrisch geformt, wobei sich der beim Schwenken des Spannhebels wirksame Hebelarm vom Anfang zum Ende der Oeffnung hin verkürzt. Griffseitig sind Schiebehebelarme (21) vorgesehen, die über einen Griffsteg (19) zwei Spannhebel (21) zu einem Doppelhebel verbinden. Die Schiebehebelarme sind sowohl in eingeschobener als auch in herausgezogener und ausgeschwenkter Position arretierbar.

FIG.1

152/79
Rz/dh

Ein-Ausziehvorrichtung für Baugruppen

Die Erfindung betrifft eine Ein-Ausziehvorrichtung nach dem Oberbegriff des Anspruchs 1.

Ein-Ausziehvorrichtungen erleichtern das Einstecken und Herausziehen von Einschüben, insbesondere von Leiterplatten oder Baugruppen für elektrische oder elektronische Schaltkreise und Bauelemente. An der Rückseite der Baugruppen sind üblicherweise Steckerleisten mit Steckerkontakten für Steckverbindungen angebracht. Diese Steckerkontakte werden beim Einschieben der Baugruppen in den Baugruppenträger in dazu passende Aussparungen bzw. Führungselemente von Feder- bzw. Buchsenleisten eingeführt, die am Baugruppenträger befestigt sind. Die erforderliche Kraft zum Einschieben und Herausziehen nimmt proportional zur Anzahl der Kontakte zu.

Eine derartige für Steck- und Andruckkontaktverbinder geeignete Ein- Ausziehvorrichtung ist aus der DE-OS 2 708 078 bekannt. Dort wird die Schwenkbewegung eines Spannhebels über Ritzel, Zahnstangen und Nocken auf einen Schieber übertragen, der die beweglichen Kontakte der Andruckverbinder schliesst bzw. öffnet. Beim Schliessen greift ein Haken am

- 2 -

kürzeren Ende des Spannhebels hinter einen Sperrstift und verklinkt damit den Einschub in der Halterung. Am griffseitigen Ende des Spannhebels ist eine Sperrklinke vorgesehen, die den Spannhebel in der hochgeschwenkten Stellung verriegelt.

Aufgabe der Erfindung ist es, eine Ein-Ausziehvorrichtung anzugeben, die einfach im Aufbau und vielseitig in der Verwendbarkeit ist.

Die Aufgabe wird in Verbindung mit den Merkmalen des Oberbegriffs gemäss dem kennzeichnenden Teil des Anspruchs 1 gelöst. Weiterbildungen der Erfindung sind in den Unteransprüchen beschrieben.

Ein Vorteil der Erfindung besteht darin, dass besondere Einrichtungen, wie Ritzel, Zahnstangen und Schieber, zum Uebertragen der erforderlichen Zieh- und Steckkräfte auf die Steck- oder Andruckverbindungen entfallen. Die Führungsöffnung bzw. -nut zwischen den Teilhebelarmen des Spannhebels ist so angeordnet, dass die wirksame Hebellänge am Anfang dieser Oeffnung grösser ist als an deren Ende. Bei einem Schwenken des Spannhebels wirken Kraftkomponenten zwischen jeweils einem der Teilhebelarme und einem am Baugruppenträger befestigten Arretiersteg in Verschiebungsrichtung der Baugruppe und bewirken direkt die gewünschte Verschiebung.

Gemäss einer bevorzugten und fertigungstechnisch einfach zu realisierenden Ausgestaltung der Erfindung ist diese Führungsnut kreiszylindrisch ausgebildet. Ein weiterer Vorteil

- 3 -

der Erfindung ergibt sich in Verbindung mit der Verwendung von Arretierschienen mit lotrechten Arretierstegen, an welchen die Teilhebelarme des Spannhebels beim Einschieben bzw. Herausziehen kraftmässig angreifen. Die Arretierstege können in genormten, äquidistanten Abständen vorgesehen sein und somit eine grosse Flexibilität bezüglich der benachbarten Anordnung schmaler und/oder breiter Baugruppen bieten. Ausser diesen Stegen können in den Arretierschienen auch Bohrungen mit und ohne Gewinde z.B. für Schraubbefestigungen von selten auszuwechselnden Baugruppen vorgesehen sein. Damit ist auf einfache Weise eine grosse Vielseitigkeit im Hinblick auf die Kombinierbarkeit von Baugruppen gewährleistet. Durch die Ausbildung des griffseitigen Hebelarms als Schiebehebelarm steht für eine Betätigung des Spannhebels ein grosser Hebelarm zur Verfügung, ohne dass dieser Hebelarm in eingeschobener und arretierter Position der Baugruppe an der Frontplatte derselben nennenswert hervorragt. Er kann in dieser Position von einer am Baugruppenträger angebrachten Abdeckplatte verdeckt sein. Vorteilhaft lässt sich durch die Gestaltung des Griffes des Schiebehebelarms ohne eine besondere Verriegelungsvorrichtung sowie zusätzlich mit einem Federelement eine Arretierung des Spannhebels bewirken und somit die Baugruppe gegen ein unbeabsichtigtes Herausrutschen aus dem Baugruppenträger sichern. Zum Herausnehmen aus dem Baugruppenträger kann die Baugruppe leicht und ohne Werkzeug entriegelt werden. Sie lässt sich am Schiebehebel, der auch als Doppelhebel ausgebildet sein kann, tragen. Ein besonderer Vorteil der erfindungsgemässen Ein-Ausziehvorrichtung ist darin zu sehen, dass sie ohne grosse Veränderungen in bestehenden, genormten Baugruppenträgern verwendet werden kann.

- 4 -

Die Erfindung wird nachstehend anhand von Ausführungsbeispielen beschrieben. Es zeigen:

Fig. 1    eine ausschnittsweise perspektivische Ansicht eines
          Baugruppenträgers mit teilweise herausgezogenen
          Baugruppen,

Fig. 2    einen vergrösserten Ausschnitt aus Fig. 1 mit einem
          in die Führungsnut zwischen den Teilhebelarmen eingreifenden Arretiersteg, teilweise geschnitten, und

Fig. 3    einen vergrösserten Ausschnitt aus Fig. 1 mit einem
          teilweise geschnittenen Spannhebel und einem diesen
          Spannhebel arretierenden Federelement in Draufsicht.

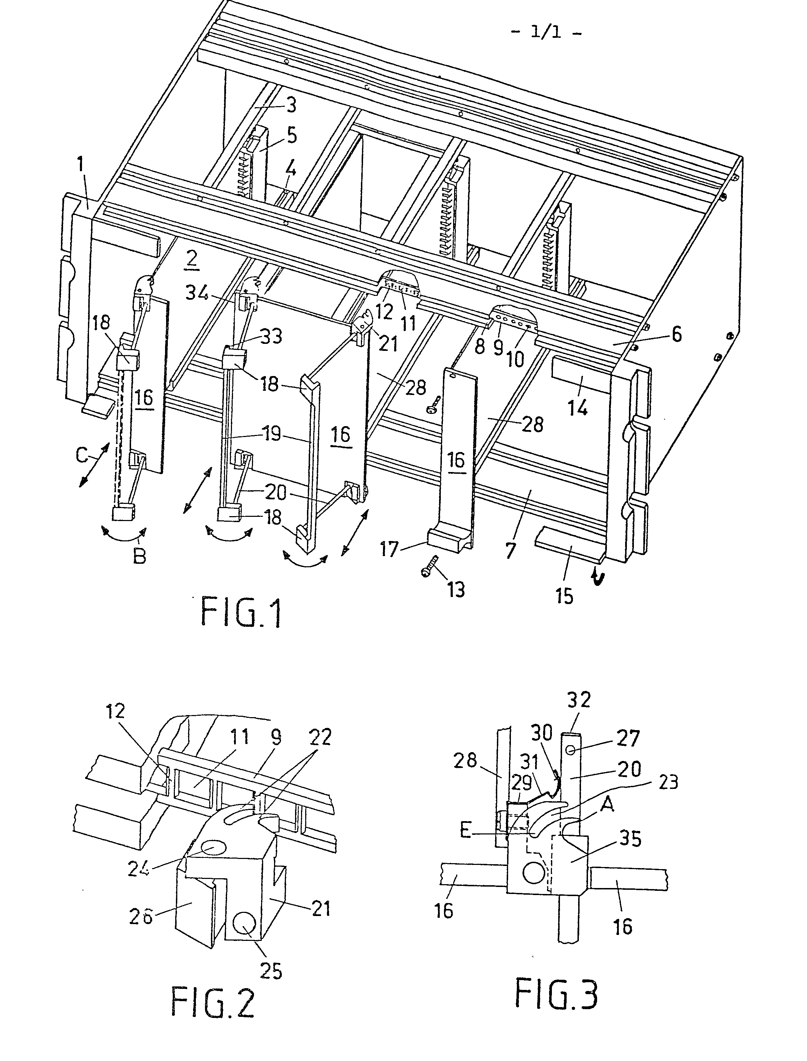

In Fig. 1 sind drei teilweise aus einem Baugruppenträger 1
herausgezogene Baugruppen 2 dargestellt. Diese Baugruppen
sind längs am Baugruppenträger befestigter, oberer Führungsschienen 3 und unterer Führungsschienen 4 verschiebbar geführt. Dabei greifen mit elektrischen und/oder elektronischen Schaltkreisen und Bauelementen bestückte Platinen
oder Leiterplatten 28 in passende Nuten ein, die in diesen
Führungsschienen vorgesehen sind. An der Rückseite dieser
Baugruppen 2 sind Steckerleisten bzw. Mehrfachsteckvorrichtungen 5 angebracht, deren nicht gezeigte Steckerkontakte
beim Einschieben der Baugruppe in den Baugruppenträger mit
Federelementen von an sich bekannten und deshalb nicht dargestellten Feder- bzw. Buchsenleisten an der Rückseite des
Baugruppenträgers in Kontakt gebracht werden.

An der Frontseite des Baugruppenträgers 1 sind eine obere

- 5 -

Profilleiste 6 und eine untere Profilleiste 7 mit je einer
T- oder kreuzförmigen Nut 8 zur Aufnahme je einer Arretierschiene 9 befestigt. In Fig. 1 und vergrössert in Fig. 2
ist ausschnittsweise nur die obere Arretierschiene zu sehen.
Aus dieser Arretierschiene 9 sind Aussparungen 11 ausgestanzt oder in anderer Weise gebildet. Arretierstege 12 zwischen diesen Aussparungen 11 dienen zum Eingriff der Teilhebelarme 22 eines Spannhebels 21, wobei ein derartiger
Arretiersteg 12 in die Führungsöffnung bzw. -nut 23 zwischen
diesen beiden Teilhebelarmen eingreift.

Im rechten Teil des Baugruppenträgers 1 weist die Arretierschiene 9 Gewindelöcher 10 auf. Diese dienen zur Befestigung von selten oder nicht zu wechselnden Baugruppen z.B.
mittels Schrauben 13. Zum Einschieben und Herausziehen ist
an der Frontplatte 16 dieser Baugruppen ein Festgriff 17
vorgesehen.

Im mittleren Teil des Baugruppenträgers 1 ist eine breite
Baugruppe mit zwei Leiterplatten 28 dargestellt, an deren
Frontplatte 16 oben und unten sowie links aussen und rechts
aussen vier Spannhebel angebracht sind. Jeder dieser Spannhebel weist griffseitig einen Schiebehebelarm 20 auf, der
in den Richtungen des Doppelpfeils C in einer passenden
Schiebehebelaussparung 25 im Spannhebel 21 verschiebbar gelagert ist, vergleiche Fig. 2. Wie Fig. 3 zeigt, ist der
Schiebehebelarm 20 gegen ein unbeabsichtigtes Herauszienen aus
dem Spannhebel 21 durch einen Sicherungsstift 27 geschützt.
Am Schiebehebelarm 20 ist ein Schiebegriff 18 mit abgewinkeltem Griffteil 33 befestigt. Die Schiebegriffe 18 von übereinander bzw. untereinander angeordneten Spannhebeln 21 sind

- 6 -

über einen Griffsteg 19 miteinander verbunden und bilden so einen Doppelhebel. Sind die Schiebehebelarme 20 herausgezogen, wie in Fig. 1 dargestellt, so können sie entsprechend dem Doppelpfeil B im Uhrzeigersinn oder entgegen dem Uhrzeigersinn um eine in einem Hebelachsenlager 26 angebrachte Hebelachse 24 geschwenkt werden, vergleiche Fig. 2 und 3. Die Schwenkbewegung des Spannhebels 21 ist einerseits, siehe Fig. 3, durch den Anschlag einer Schiebehebelarmführung 35 gegen die Frontplatte 16 und andererseits durch den Anschlag des Endteils 32 des Schiebehebelarms 20 gegen das Hebelachsenlager 26 begrenzt. In nicht dargestellter, eingeschobener Position des Schiebehebelarms 20 kommt das abgewinkelte Griffteil 33 zur Anlage an eine Griffanlegekante 34 der Frontplatte 16, wodurch ein Schwenken des Hebels ohne vorheriges Herausziehen verhindert wird. Gleichzeitig drückt ein Andruckbogen 30 eines Federelementes 29 gegen den Schiebehebelarm 20 und sichert diesen gegen ein Schwenken und unbeabsichtigtes Herausgleiten. In herausgezogener und gegenüber der eingeschobenen Position abgewinkelter Stellung, entsprechend Fig. 1, ist das Endteil 32 des Schiebehebelarms 20 in einem gewinkelten Arretierteil 31 des Federelementes 29 unter Federspannung arretiert bzw. gegen ein unbeabsichtigtes Schwenken gesichert.

Bei der im linken Teil von Fig. 1 dargestellten schmalen Baugruppe mit nur einer Leiterplatte ist der Griffsteg 19 gestrichelt gezeichnet zum Zeichen dafür, dass er entfallen kann. Die Griffe 18 sind bei dieser Ausführung in eingeschobener Position der Baugruppen und Schiebehebelarme ganz von einer oberen Abdeckleiste 14 und einer aufgeklappt dargestellten unteren Abdeckleiste 15, die am Baugruppenträger

- 7 -

schwenkbar und verriegelbar befestigt sind, abdeckbar. Damit wird das Aussehen der Frontseite des Baugruppenträgers 1 nicht durch vorragende Griffe gestört oder beeinträchtigt.

Fig. 2 zeigt einen Spannhebel 21, dessen Schiebehebelarm nicht dargestellt ist, im Eingriff mit einem Arretiersteg 12. Die Weite der Führungsnut 23 zwischen den Teilhebelarmen 22 ist der Abmessung des Arretiersteges 12 angepasst, wobei die Führungsflächen der Führungsnut 23 im wesentlichen kreiszylindrisch geformt sind. Der nicht dargestellte Krümmungsmittelpunkt dieser kreiszylindrischen Führungsflächen liegt exzentrisch zur Hebelachse 24, so dass sich die Länge des wirksamen Teilhebelarms 22 mit dem Schwenkwinkel im Schwenksinn der Entriegelung bzw. des Herausziehens der Baugruppe zwischen dem Ende E und dem Anfang A eines Teilhebelarms 22 stetig vergrössert. Beim Einschieben der Baugruppe wird zunächst ein zuverlässiges Hintergreifen des Arretiersteges 12 durch den hinteren Teilhebelarm 22 und anschliessend eine relativ starke Schubbewegung der Baugruppe in Einschubrichtung erreicht. Die gebogenen Teilhebelarme 22 erlauben relativ eng benachbarte Arretierstege 12 in der Arretierschiene 9 und ermöglichen somit eine grosse Flexibilität hinsichtlich der Anordnung von Baugruppen innerhalb des Baugruppenträgers.

Die Wirkung der Ein-Ausziehvorrichtung wird anhand der Fig. 1 bis 3 beschrieben. Zunächst werden die Schiebehebelarme 20 des Spannhebels 21 an den Schiebegriffen 18 bis zum Anschlag des Sicherungsstiftes 27 an der Schiebehebelarmführung 35 herausgezogen und bezüglich ihrer eingeschobenen Position bis zum Anschlag gegen das Hebelachsenlager 26

- 8 -

geschwenkt. Dann wird die Baugruppe 2 bzw. die Leiterplatte 28 bei entriegelter und aufgeklappter oberer und unterer Abdeckleiste 14 und 15 in der Führungsnut der oberen und unteren Führungsschiene 4 und 5 bis zur Anlage der Anfangsabschnitte A der Teilhebelarme 22 an den zur Verriegelung vorgesehenen Arretierstegen 12 der Arretierschiene 9 nach hinten geschoben. Die Spannhebel 21 werden nun in ihre Ausgangsposition zurückgeschwenkt, wobei die Stege 12 längs der Führungsnuten 23 dieser Spannhebel gleiten, am Ende E der Teilhebelarme 22 zur Anlage kommen und dabei die Stecker der Mehrfachsteckvorrichtung 5 mit den zugehörigen Federelementen von nicht dargestellten Federleisten in Kontakt bringen. Jetzt werden die Schiebehebelarme 20 gegen die Frontplatte 16 gedrückt, bis die abgewinkelten Griffteile 33 an der Anlagekante 34 der Frontplatte anliegen. Die Griffe 18 können nun durch die Abdeckleisten 14 und 15 verdeckt werden. Das Herausziehen der Baugruppen 2 aus dem Baugruppenträger 1 geschieht analog und braucht daher nicht mehr erläutert zu werden.

Die Erfindung ist auf das in den Zeichnungen 1 bis 3 Dargestellte selbstverständlich nicht beschränkt. So könnten die Führungsflächen in der Führungsnut 23 der Teilhebelarme 22 Abschnitte mit geringerer und stärkerer Krümmung aufweisen, wobei z.B. die Stärke der Krümmung umgekehrt proportional zur Stärke der in dem jeweiligen Abschnitt zu übertragenen Kraft ist. Anstelle durchgehender Arretierstege 12 könnten Arretierstifte oder Arretierzapfen vorgesehen sein. Das Federelement 29 kann durch andere Arretiervorrichtungen ersetzt werden. Es können z.B. im Schiebehebelarm 20 Aussparungen in Kugelkalottenform vorgesehen sein, in welche zur Arretierung eine passende Kugelkappe

- 9 -

gedrückt wird. Die Schiebehebelarme können eine rechteckige, prismatische, T-förmige oder eine andere von der kreiszylindrischen verschiedene Querschnittsform aufweisen. Die Hebelgriffe könnten z.B. mit Sperrklinken versehen oder mit anderen Arretiervorrichtungen ausgestattet sein.

Die erfindungsgemässe Ein-Ausziehvorrichtung ist besonders für elektronische Baueinheiten geeignet.

0031181

152/79

- 10 -

Patentansprüche

1. Ein-Ausziehvorrichtung für Baugruppen in Baugruppenträgern (1)

a) mit einem an dieser Baugruppe drehbar gelagerten zweiarmigen Hebel (21),

b) der spannseitig zwei Teilhebelarme (22) aufweist, welche eine Führungsnut (23) begrenzen,

c) mit wenigstens einem am Baugruppenträger befestigten Arretierstift bzw. -steg (12) für den Eingriff dieser Teilhebelarme, wobei der Arretiersteg in diese Führungsnut eingreift,

dadurch gekennzeichnet, dass

d) die für eine Kraftübertragung wirksame Länge eines Teilhebelarms (22) an dessen Anfangsabschnitt (A) grösser ist als die Länge an dessen Ende (E).

2. Ein-Ausziehvorrichtung nach Anspruch 1, dadurch gekennzeichnet, dass

die wirksame Länge eines Teilhebelarms (22) zwischen dessen Ende (E) und Anfang (A) stetig zunimmt.

- 11-

3. Ein-Ausziehvorrichtung nach Anspruch 2, dadurch gekennzeichnet, dass

die Teilhebelarme (22) an deren Führungsnut (23) im wesentlichen kreiszylindrisch geformte Führungsflächen aufweisen.

4. Ein-Ausziehvorrichtung nach den Ansprüchen 1 bis 3, dadurch gekennzeichnet, dass

der eingriffseitige Hebelarm als in seiner wirksamen Länge veränderbarer Schiebehebelarm (20) ausgebildet ist.

5. Ein-Ausziehvorrichtung nach den Ansprüchen 1 bis 4, dadurch gekennzeichnet, dass

der Schiebehebelarm (20) einen abgewinkelten Griff (18) aufweist, dessen abgewinkeltes Griffteil (33) in eingeschobener, arretierter Position des Schiebehebelarms an einer Griffanlegekante (34) der Baugruppe (2) anliegt.

6. Ein-Ausziehvorrichtung nach den Ansprüchen 1 bis 5, dadurch gekennzeichnet, dass

zwei Hebel (21) an deren griffseitigem Ende über einen Griffsteg (19) zu einem Doppelhebel verbunden sind.

7. Ein-Ausziehvorrichtung nach den Ansprüchen 1 bis 6, dadurch gekennzeichnet, dass

a) an der Baugruppe (2) ein Federelement (29) befestigt ist,

b) dass dieses Federelement in eingeschobener Position des Schiebehebelarms (20) an diesem unter Spannung anliegt und dabei den Spannhebel (21) in dieser Position arretiert,

c) dass das Federelement (29) ein gewinkeltes Arretierteil (31) aufweist, das den Schiebehebelarm (20) in herausgezogener und bezüglich der eingeschobenen Position abgewinkelter Stellung den Spannhebel (21) arretiert,

d) wobei das Arretierteil (31) am Endteil (32) des Schiebehebelarms (20) unter Spannung anliegt.

8. Ein-Ausziehvorrichtung nach den Ansprüchen 1 bis 7, dadurch gekennzeichnet, dass

a) am Baugruppenträger (1) wenigstens eine Arretierschiene (9) mit wenigstens einem Arretiersteg (12) befestigt ist,

b) wobei dieser Arretiersteg (12) lotrecht angeordnet ist.

9. Ein-Ausziehvorrichtung nach Anspruch 8, dadurch gekennzeichnet, dass

a) diese Arretierschiene (9) in einer Nut (8) einer am Baugruppenträger (1) befestigten Profilleiste (6, 7) angeordnet ist und

b) Befestigungsaussparungen (10, 11) und/oder Arretierstege (12) zur Befestigung und Arretierung von Baugruppen aufweist.

**FIG.1**

**FIG.2**

**FIG.3**

0031181

- 1/1 -